Europäisches Patentamt

(19) European Patent Office

Office européen des brevets

(11) Numéro de publication : **0 439 393 A1**

(12) **DEMANDE DE BREVET EUROPEEN**

(21) Numéro de dépôt : 91400117.7

(22) Date de dépôt : 18.01.91

(51) Int. Cl.⁵ : **G02F 1/19,** H04N 9/31

(30) Priorité : 26.01.90 FR 9000940

(43) Date de publication de la demande :
31.07.91 Bulletin 91/31

(84) Etats contractants désignés :
DE GB

(71) Demandeur : THOMSON-CSF
51, Esplanade du Général de Gaulle
F-92800 Puteaux (FR)

(72) Inventeur : **Broussoux, Dominique**
**THOMSON-CSF, SCPI, Cédex 67**
**F-92045 Paris la Défense (FR)**
Inventeur : **Robin, Philippe**
**THOMSON-CSF, SCPI, Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Modulateur électrooptique spatial et applications.**

(57)    L'invention concerne un modulateur électrooptique spatial comprenant un substrat en matériau électrooptique recouvert de moyens métalliques de réflexion et comprenant des moyens d'application d'un champ électrique au substrat, l'épaisseur de la couche métallique et l'"indice de réfraction du substrat étant tels qu'un champ électrique appliqué au substrat induit une variation de la valeur de la réflectivité de la couche métallique.
   Application au traitement spatial optique du signal (par exemple interrupteur optique à mémoire spatiale).

EP 0 439 393 A1

FIG_4

# MODULATEUR ELECTROOPTIQUE SPATIAL ET APPLICATIONS

La présente invention concerne un modulateur électrooptique spatial composé d'un substrat en matériau électrooptique sur lequel est déposée une mince couche de métal.

D'une manière générale, les modulateurs électrooptiques spatiaux de lumière (MESL) fonctionnant en réflexion ou en transmission sont de structure souvent complexe, lents, monochromatiques ou de faible contraste. Certains allient plusieurs de ces inconvénients à la fois.

On trouvera des descriptions de ces structures ainsi que leurs performances dans les articles : "Electronic Projection Displays (Seminar 14, R.I. FEIGENBLATT, IBM T.J. Watson Research Center, Yorktown Heights, NY, SID 1987)", "Le point sur les modulateurs spatiaux de lumière (G. LEBRETON, Revue Phys. Appl. 22, 1987, pp. 1309-1320)" et "Spatial Light Modulators and their Applications (J.P. HUIGNARD, J. Optics, Paris, 1987, vol. 18, n° 4, pp 181 - 186)". Quels que soient les dispositifs décrits, en excluant les écrans à cristal liquide à adressage électrique, les MESL tels que les valves optiques à photoconducteur, les valves optiques à miroirs déformants ou les valves optiques à cristal liquide adressé thermiquement présentent tous des structures multicouches complexes, des temps de réponse longs (de la milliseconde à la seconde), des résolutions spatiales limitées (10 à 20 pixels par mm) et nécessitent un encombrement important à cause des techniques d'adressage optique utilisées. Dans le cas du MESL à miroirs déformants, outre la technologie complexe se pose les problèmes de temps de réponse limité par la mécanique et d'efficacité qui se dégrade avec le temps par la migration d'ions dans la couche de polymère.

Un autre type de MESL consiste en une couche de cristal liquide adressé par une matrice de transistors TFT sur silicium amorphe ou polycristallin. Ce type de structure est moins complexe et technologiquement bien avancée, mais elle reste limitée à cause de son temps de réponse long (de l'ordre de la milliseconde) et du problème thermique important qu'elle pose durant son utilisation.

C'est pour pallier tous ces inconvénients que l'invention a été conçue. Elle est basée sur le fait qu'on peut moduler le coefficient de réflexion d'un faisceau lumineux incident à une couche métallique par application d'un champ électrique à un substrat adjacent à cette couche métallique. On peut ainsi obtenir un dispositif de conception très simple et de haute résolution (la résolution n'étant limitée que par la résolution des circuits d'adressage électrique). Ce dispositif présente en outre un contraste élevé (supérieur à 100), un temps de réponse inférieure à la picoseconde, une possibilité de polychromaticité. Il peut utiliser des techniques d'adressage multiples (CCD, transistors TFT sur silicium amorphe ou polycristallin, adressage thermique par faisceau laser ou électriquement par effet Joule).

L'invention a donc pour objet un modulateur électrooptique spatial caractérisé en ce qu'il comprend un substrat en matériau électrooptique recouvert de moyens métalliques de réflexion et comprenant des moyens d'application d'un champ électrique au substrat, l'épaisseur de la couche métallique et l'indice de réfraction du substrat étant tels qu'un champ électrique appliqué au substrat induit une variation de la valeur de la réflectivité de la couche métallique.

L'invention sera mieux comprise et d'autres avantages apparaîtront à la lecture de la description qui va suivre, donnée à titre non limitatif, accompagnée des figures annexées parmi lesquelles :

- la figure 1 représente un dispositif permettant de mesurer la réflectivité d'une couche métallique déposée sur un substrat en fonction de l'angle d'incidence d'un faisceau luminieux,
- les figures 2 et 3 sont des diagrammes de réflectivité en fonction de l'angle d'incidence,
- la figure 4 représente un modulateur pour lecture optique de signaux hydrophoniques selon l'invention,
- la figure 5 représente un modulateur spatial pour faisceau infrarouge selon l'invention,
- la figure 6 représente un interrupteur optique à mémoire spatiale selon l'invention,
- la figure 7 représente un modulateur électrooptique spatial pour projection d'images télévision selon l'invention,
- la figure 8 représente une variante du modulateur de la figure 7,
- la figure 9 est un diagramme de réflectivité,
- la figure 10 illustre un système de lecture optique selon l'invention d'une mémoire WRM à substrat ferroélectrique.

L'invention concerne le domaine du traitement optique spatial du signal. En effet, le modulateur selon l'invention peut être employé pour moduler spatialement un faisceau lumineux. La modulation est induite par la variation de réflectivité d'une couche métallique servant d'électrode et qui peut être constituée d'une métallisation continue ce qui a pour effet de moduler entièrement toute la surface du faisceau réfléchi. Cette couche métallique peut aussi être matrice en électrodes commandées individuellement ce qui a pour effet de moduler spatialement le faisceau réfléchi. Les temps de réponse de ce type de modulation sont inférieurs à la nanoseconde et sont essentiellement gouvernés par l'impédance des électrodes et par la charge et la décharge de la capacité constituée par le pixel défini par l'arrangement matriciel ou par le pixel en parallèle sur les pixels de la même colonne.

Le modulateur selon l'invention peut concerner les applications particulières suivantes : la modulation électrooptique spatiale d'un faisceau lumineux, la modulation électrooptique spatiale d'un faisceau infrarouge, un interrupteur optique spatial à mémoire, la modulation spatiale d'un écran pour projection d'image, un système de lecture d'une mémoire RWM (Read Write Many).

En fait, l'invention s'applique à tous les systèmes qui, d'une façon ou d'une autre, nécessitent de moduler spatialement un faisceau optique de puissance instantanée inférieure au $GW/cm^2$ ou de puissance continue inférieure au $W/cm^2$, quelle que soit la longueur d'onde utilisée entre ultra-violet et infra-rouge.

Selon l'invention, la modulation de l'amplitude (ou de la phase) du faisceau lumineux incident et se réfléchissant sur la couche métallique est obtenue en appliquant une tension alternative ou continue sur le substrat électrooptique. Cette tension induit une variation d'indice dans le substrat entraînant une variation de réflectivité de la couche métallique.

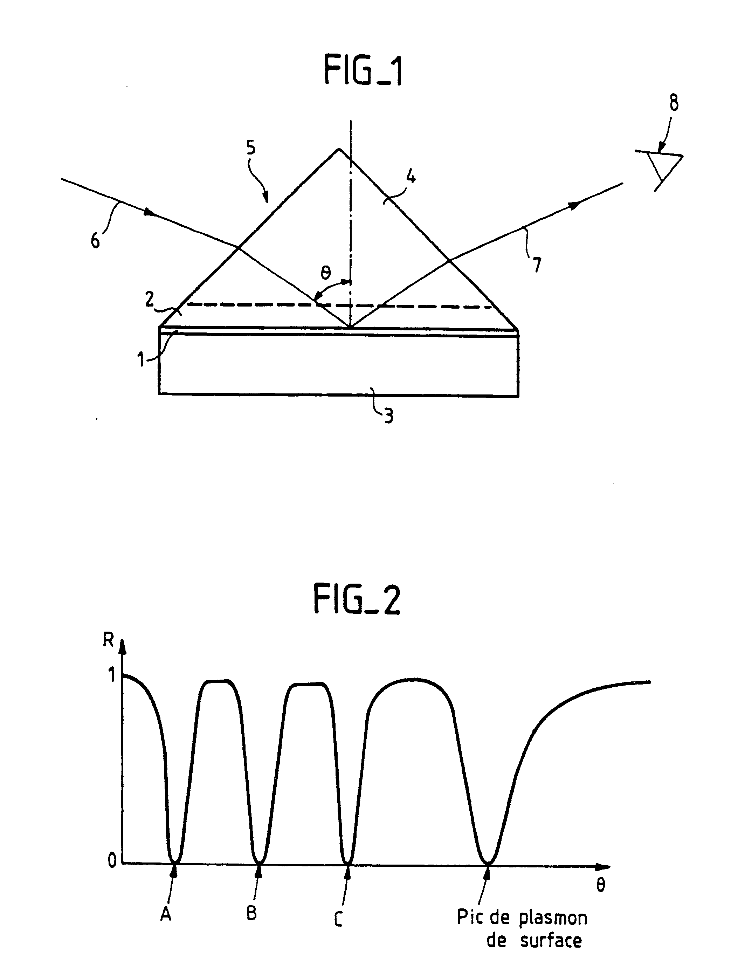

Le principe physique qui est la base de l'invention va être décrit en relation avec les figures 1 à 3.

Une couche d'argent 1 de 500 angströms d'épaisseur est déposée sur une lame de verre 2, par exemple par évaporation sous vide. On dépose, côté couche d'argent, par la méthode dite à la tournette, une couche de polymère 3 de quelques μm d'épaisseur pour former le substrat. Un prisme 4 est associé à la lame de verre 2 et l'ensemble constitue également un prisme, une goutte d'huile ayant été placée entre les éléments 2 et 4 pour éviter les réflexions à ce niveau. Grâce à cette façon de procéder, le dépôt à la tournette du polymère 3 se fait correctement, la lame 2 présentant des faces planes.

On peut ainsi mesurer la réflectivité R de la couche d'argent 1, l'ensemble constitué par les éléments 2 et 4 constituant un prisme de haut indice 5. La mesure de la réflectivité de la couche d'argent peut se faire à l'aide d'un couplage par réseau au lieu d'un couplage par prisme. Dans ce cas, un réseau est déposé sur la lame de verre à l'aide d'une résine photosensible.

Un faisceau lumineux 6 fourni par un laser hélium-néon est dirigé vers la couche d'argent 1 au travers du prisme 5. Le faisceau lumineux 7 réfléchi par la couche 1 et émanant du prisme 5 est détecté par une photodiode 8.

La figure 2 est un diagramme représentant la réflectivité R de la couche d'argent 1 en fonction de l'angle θ que fait le faisceau lumineux incident à la couche 1 et la normale à cette couche. La valeur de la réflectivité R (rapport des intensités lumineuses des faisceaux 7 et 6) varie entre 0 et 1. Il existe donc des valeurs de l'angle θ pour lesquelles la réflectivité R est égale à 1 (réflexion totale) et d'autres pour lesquelles R est nulle (réflexion nulle).

Le pic de réflectivité situé le plus à droite sur le diagramme de la figure 2 est appelé pic de plasmon de surface car il correspond à l'absorption du faisceau lumineux par les plasmons de surface de la couche d'argent. Pour cette valeur de l'angle θ, toute l'énergie du faisceau lumineux est absorbée dans la couche métallique. Les autres pics (A, B et C) correspondent à l'excitation des modes guidés qui peuvent exister dans la couche de polymère.

La position angulaire de tous ces pics est déterminée à la fois par l'épaisseur et par l'indice de réfraction de la couche 3 adjacente à la couche métallique.

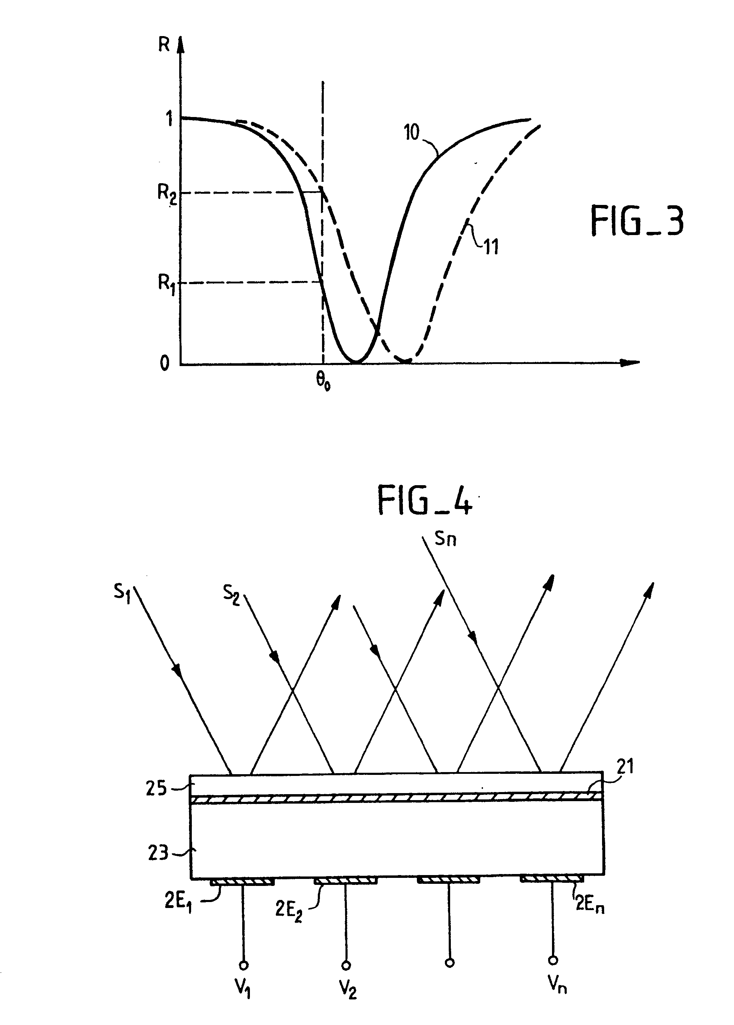

On va considérer l'un des pics, par exemple le pic A comme le montre le diagramme de la figure 3 (courbe 10). Si à la couche de polymère 3 on applique un champ électrique continu, on induit dans le polymère une variation d'indice Δ n et également une variation d'épaisseur Δ e. La courbe de réflectivité R en fonction de l'angle θ se modifie, par exemple de la façon représentée en traits interrompus sur le diagramme de la figure 3 (courbe 11).

Pour un angle d'incidence déterminé, les valeurs de réflectivité seront donc différentes selon le champ électrique vu par le substrat 3. Ainsi, pour l'angle d'incidence $θ_0$, à un champ électrique par exemple nul correspond une valeur de réflectivité $R_1$ et à un champ électrique continu de valeur non nulle correspond une valeur de réflectivité $R_2$.

Ainsi, si l'angle d'incidence θ est fixé, on peut engendrer des variations de réflectivité associées à l'application d'un champ électrique sur le substrat.

La variation de réflectivité dépend essentiellement de l'importance de l'effet électrooptique induit dans le substrat. En effet, Δ R peut s'écrire dans la partie quasiment linéaire de la courbe R = f (θ) de la manière suivante :

$$\Delta R = A.\ \Delta n = \frac{A.r.n^3}{2} \times \frac{Va}{e}$$

où A est un facteur de proportionalité variant entre $10^2$ et $5.10^2$, r est le coefficient électrooptique du substrat à la longueur d'onde de lecture, n est l'indice optique du substrat à la longueur d'onde du faisceau incident, Va est la valeur de la tension continue ou alternative appliquée et e est l'épaisseur du substrat.

Si on utilise comme substrat des polymères ferroélectriques tels que le polyfluorure de vinylidène PVDF ou ses copolymères poly (fluorure de vinylidène/trifluoroéthylène) P (VDF-TrFE), l'indice n à λ = 0, 633 nm est compris entre 1,4 et 1,45 et le coefficient électrooptique vaut approximativement $10^{-12}$ m/V.

Si on utilise comme substrat les polymères amorphes décrits dans le document FR 2 630 744, l'indice n à λ = 0,633 nm est compris entre 1,55 et 1,65 et le coefficient électrooptique peut atteindre 15 à 20. $10^{-12}$ m/V. Dans le meilleur des cas, pour obtenir une variation de réflectivité ΔR = 0, 1 pour un substrat de 1 μm d'épaisseur, la tension à appliquer au substrat sera égale à 4 volts.

Une variation de réflectivité égale à 100 % (passage de la réflexion totale à une absence totale de réflexion) est atteinte pour 40 volts. On remarque aussi que lorsque le modulateur est passant, les pertes de puissance du faisceau incident sont très faibles puisque le faisceau est en état de réflexion totale sur un métal.

Le calcul de la réflectivité minimale détectable peut être apprécié en se plaçant dans deux cas extrêmes : d'abord le cas où le faisceau incident est étendu et où la lecture de la modulation spatiale se fait par un dispositif à transfert de charges ou CCD (premier cas), ensuite le cas où le faisceau est ponctuel et où la lecture de la modulation du faisceau se fait sur un photodétecteur ponctuel (deuxième cas).

Dans le premier cas, on peut utiliser un faisceau lumineux fournissant une puissance incidente de 1 mW étendue sur 1 cm² et un CCD de détectivité par pixel d'environ $10^{12}$ m.

$$\sqrt{Hz}/W.$$

Pour une fréquence de lecture de 7 MHz, on calcule la puissance minimum du signal que l'on peut discerner dans le bruit d'obscurité ou NEP (Noise Equivalent Power) pour une bande de 3,5 MHz et pour une surface de pixel égale à $169.10^{-12}$ m². On trouve un NEP égal à $2.10^{-14}$ W d'où le minimum de réflectivité détectable :

$$R_{mini} = NEP/P_i \simeq 10^{-5}$$

avec $P_i = 1,7.10^{-9}$ W/pixel. Ce minimum de réflectivité détectable correspond à une tension appliquée de $5.10^{-5}$ volts.

Dans le deuxième cas, on utilise un photodétecteur standard ayant une détectivité d'environ $10^{10}$ m.

$$\sqrt{Hz}/W,$$

ce qui conduit pour une surface de 10 mm² à un NEP de $3.10^{-10}$W pour une bande passante de 100 kHz. Le minimum de réflectivité correspondant est :

$$R_{mini} = NEP/P_i \simeq 3.10^{-7}$$

avec $P_i = 10^{-3}$ W/pixel. Ce minimum de réflectivité détectable correspond alors à une tension appliquée de $2.10^{-5}$V. On remarque tout de suite que le $\Delta R_{mini}$ est fonction de la densité de puissance incidente, ce qui explique la différence entre un CCD et un détecteur ponctuel. Il faut en outre tenir compte des fluctuations des sources lumineuses, du bruit de ces sources, du bruit thermique du substrat qui s'échauffe pendant le cycle de réflexion minimale et du bruit diélectrique du modulateur. Tous ces facteurs entraînent une dégradation de la réflectivité minimale détectable.

On va décrire maintenant des exemples d'application du modulateur électrooptique spatial selon l'invention.

EXEMPLE 1

Cet exemple concerne un modulateur pour lecture optique de signaux hydrophoniques (fonction capteur). Cet exemple est illustré par la figure 4. Ce modulateur est constitué d'une électrode 21 en argent prise en sandwich entre le substrat électrooptique 23 et le réseau de couplage 25. Le substrat 23 comporte, sur sa face externe et en regard de l'électrode 21, des électrodes $E_1$, $E_2$... $E_n$ sous forme de plots. Ces électrodes sont destinées à appliquer au substrat des tensions $V_1$, $V_2$... $V_n$ délivrées respectivement par des hydrophones $H_1$, $H_2$. . . $H_n$, l'électrode 21 étant reliée à la masse. Une matrice de lasers ou une matrice de fibres optiques alimentées par une seule source délivre des faisceaux de lumière cohérente $S_1$, $S_2$... $S_n$ en direction de zones de l'électrode 21 situées en regard respectivement des électrodes $2E_1$, $2E_2$... $2E_n$. Ces faisceaux lumineux sont destinés à être réfléchis par l'électrode 21 en autant de faisceaux $D_1$, $D_2$...$D_n$.

La tension développée entre l'une des électrodes $E_i$ et l'électrode 21 est appelée $V_{pixel}$. Elle se calcule de la manière suivante :

$$V_{pixel} = (C_{hydro}/C_{pixel}) \times (d_h.e/\varepsilon_o\varepsilon_r)\times P$$

$C_{hydro}$ étant la capacité de l'élément hydrophone (environ 1000 pF pour des pertes diélectriques de l'ordre de 1 %),

$C_{pixel}$ étant la capacité du pixel de lecture (environ 100 pF),

$d_h$ étant le coefficient piézoélectrique hydrostatique (environ 10 pC/N pour le PVDF),

e étant l'épaisseur de l'élément hydrophone (environ 1 mm),

$\varepsilon_r$ étant la constante diélectrique de l'élément hydrophone (environ égale à 10),

$\Delta P$ étant la pression hydrostatique.

La tension minimale détectable est limitée par le bruit. La tension de bruit est :

$$< V^2 > = (4kT) \times (tg\ \delta\ /C.f)$$

k étant la constante de Boltzmann, T la température absolue, tgδ les pertes diélectriques du substrat, C la capacité d'un pixel et f la fréquence.

Il vient : $< v^2 >^{\frac{1}{2}} = 4.10^{-7}$ volt pour $\Delta f = 10^3$Hz à f = $10^3$Hz.

La pression minimum détectable est :

$$<\Delta P> = < v^2 >^{\frac{1}{2}}/S_h = 4.10^{-4}N/m^2$$

avec $S_h = d_h\ e/\ \varepsilon_o\varepsilon_r$.

Il vient : $V_{pixel} = (C_{hydro}/C_{pixel}) <v^2>^{\frac{1}{2}} = 4.10^{-6}$ volt.

La variation de réflectivité due à cette tension minimale est de $5.10^{8}$, ce qui pour un faisceau de lecture de $10^{-3}$W correspond à un NEP sur la photodiode de détection de $5.10^{-11}$W. Ce NEP est compatible avec les photodiodes du commerce pour le cas où $\Delta f$ est limitée à $10^3$ (NEP $\simeq 10^{-13}$W).

Sur le dessin de la figure 4, on a représenté une seule rangée d'électrodes $2E_i$ et une seule rangée de faisceaux $S_i$ par souci de simplification, mais le modulateur selon l'invention peut comporter évidemment autant de rangées d'éléments (électrodes et faisceaux) qu'il est nécessaire.

Il entre dans le cadre de la présente invention de remplacer l'électrode 21 par des rangées d'électrodes et également les plots 2E$_i$ par d'autres rangées d'électrodes de manière à obtenir un arrangement matriciel de lignes et de colonnes.

On peut réaliser ce modulateur de la manière suivante. Le réseau de couplage est obtenu par dépôt d'une résine sur une lame de verre d'environ 1 mm d'épaisseur ou par gravure chimique de cette lame de verre. On dépose ensuite sur la face de la lame de verre opposée au réseau l'électrode (ou les électrodes) réfléchissante, puis le substrat électrooptique (par exemple un polymère ferroélectrique ou amorphe électrooptique déposé à la tournette) et ensuite les électrodes arrière par exemple par évaporation sous vide.

L'électrode réfléchissante est par exemple une couche d'argent de 500 Å d'épaisseur. Le substrat électrooptique peut avoir 1 µm d'épaisseur. Les électrodes arrière peuvent avoir de 1 000 à 2 000 Å d'épaisseur et être en cuivre, en aluminium, en argent ou en or.

## EXEMPLE 2

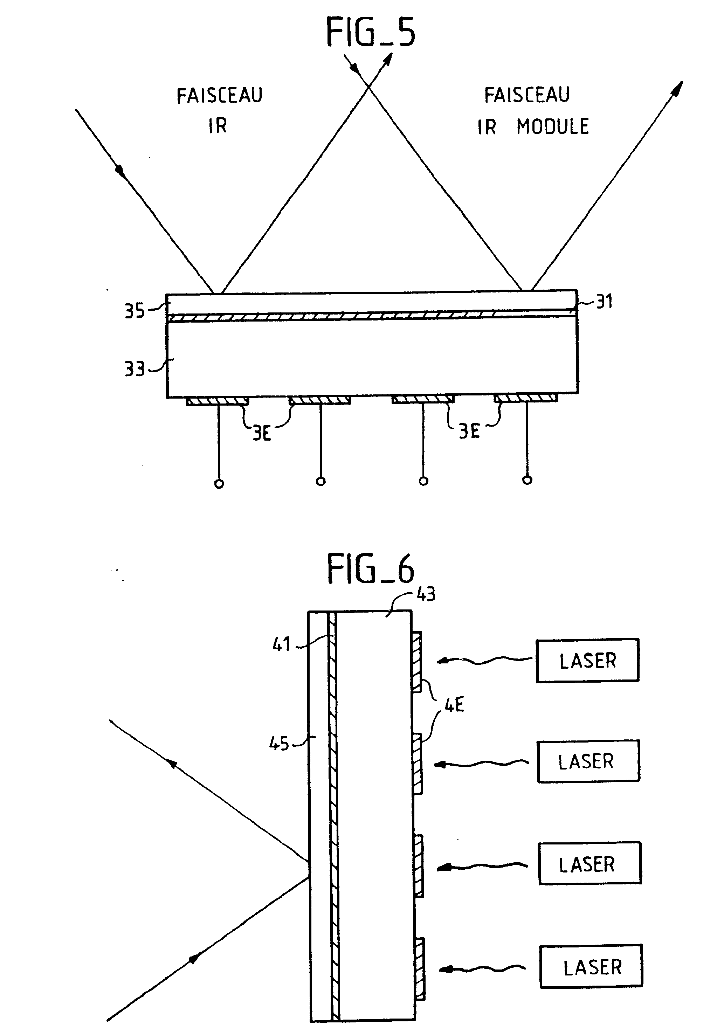

Cet exemple concerne un modulateur spatial d'un faisceau infrarouge. Cet exemple est illustré par la figure 5. Ce modulateur est constitué d'électrodes lignes 31 en argent prises en sandwich entre le substrat électrooptique 33 et le réseau de couplage 35. Le substrat 33 comporte, sur sa face externe et en regard de l'électrode 31, des électrodes colonnes 3E.

Pour ce type d'application, il est nécessaire d'adapter les épaisseurs des électrodes lignes 31 (ou de la couche métallique le cas échéant) et du substrat en fonction de la longueur d'onde du faisceau infrarouge (entre 1 et 10 µm). La puissance du faisceau infrarouge doit être limitée au W/cm² pour éviter un échauffement trop important du dispositif.

A titre d'exemple, pour un faisceau infrarouge de 1 µm de longueur d'onde on peut choisir une couche réfléchissante en argent de 500 angströms d'épaisseur et d'indice 0,07, et un substrat polymère d'épaisseur 1 µm et d'indice 1,5.

Pour un faisceau infrarouge de 4 µm de longueur d'onde, on peut choisir une couche réfléchissante en argent de 500 angströms d'épaisseur et d'indice 1,41, et un substrat polymère ferroélectrique ou amorphe électrooptique d'épaisseur 5 µm et d'indice 1,5.

Ainsi, un faisceau infrarouge incident est réfléchi par les électrodes 31 en étant modulé spatialement grâce au champ électrique généré dans le substrat électrooptique 33.

## EXEMPLE 3

Cet exemple concerne un interrupteur optique à mémoire spatiale. Cet exemple est illustré par la figure 6 où on a représenté un dispositif à affichage matriciel. Il est constitué d'électrodes lignes réfléchissantes 41 en argent prises en sandwich entre le substrat électrooptique 43 et le réseau de couplage 45. Le substrat 43 comporte, sur sa face externe et en regard des électrodes 41, des électrodes colonnes 4E. Le substrat 43 est constitué par un polymère ferroélectrique. Ce substrat possède un indice égal à 1,43 lorsqu'il n'est pas polarisé (tous les dipôles sont désorientés) et un indice égal à 1,41 lorsqu'il est polarisé (tous les dipôles sont orientés). On peut donc disposer d'un dispositif possédant des zones réfléchissantes par exemple aux endroits du substrat où n vaut 1,41 et des zones non réfléchissantes aux endroits du substrat où n vaut 1,43.

Un tel dispositif fonctionne de la façon suivante. On suppose que le substrat 43 est uniformément polarisé par application d'un champ électrique approprié entre les électrodes lignes 41 et les électrodes colonnes 4E. L'indice optique vaut alors 1,41 et toutes les zones situées aux intersections lignes-colonnes sont réfléchissantes. Le substrat étant ferroélectrique, toutes ces zones restent réfléchissantes en absence de champ électrique appliqué. Si on veut que certaines zones ne soient plus réfléchissantes, on peut pour cela chauffer les parties correspondantes du substrat au moyen d'un faisceau laser dirigé côté électrodes colonnes. Pour une meilleure efficacité, il est avantageux de prévoir une couche absorbante sur les électrodes colonnes. En les chauffant à une température supérieure à la température de Curie du substrat, ces parties de substrat passe à un indice optique de 1,43 et les zones correspondantes d'électrodes 41 ne sont plus réfléchissantes, même lorsque la température revient à la température ambiante. Pour rendre à nouveau ces zones réfléchissantes, il faut polariser à nouveau le substrat.

On obtient donc un système bistable à mémoire.

Une variation d'indice le $10^{-2}$ permet d'obtenir une variation de réflectivité égale à : $\Delta R = A . \Delta n = 5$ avec $A = 5.10^{+2}$. Cette variation est donc largement suffisante pour obtenir un état 1 (réflexion 100 %) et un état 0 (réflexion 0 %). La commutation électrique peut se faire en moins d'une µs avec une tension de l'ordre de 10 volts pour 0,1 µm d'épaisseur de polyfluorure de vinylidène ou ses copolymères à base de trifluoroéthylène. La dépolarisation peut être obtenue par absorption sur l'électrode arrière recouverte d'une couche absorbante (noir de métal par exemple). Pour 0,1 µm d'épaisseur de substrat et 10 mW de puissance incidente, le front de chaleur se propage en 100 ns et chauffe le matériau de 20°C à 110°C.

## EXEMPLE 4

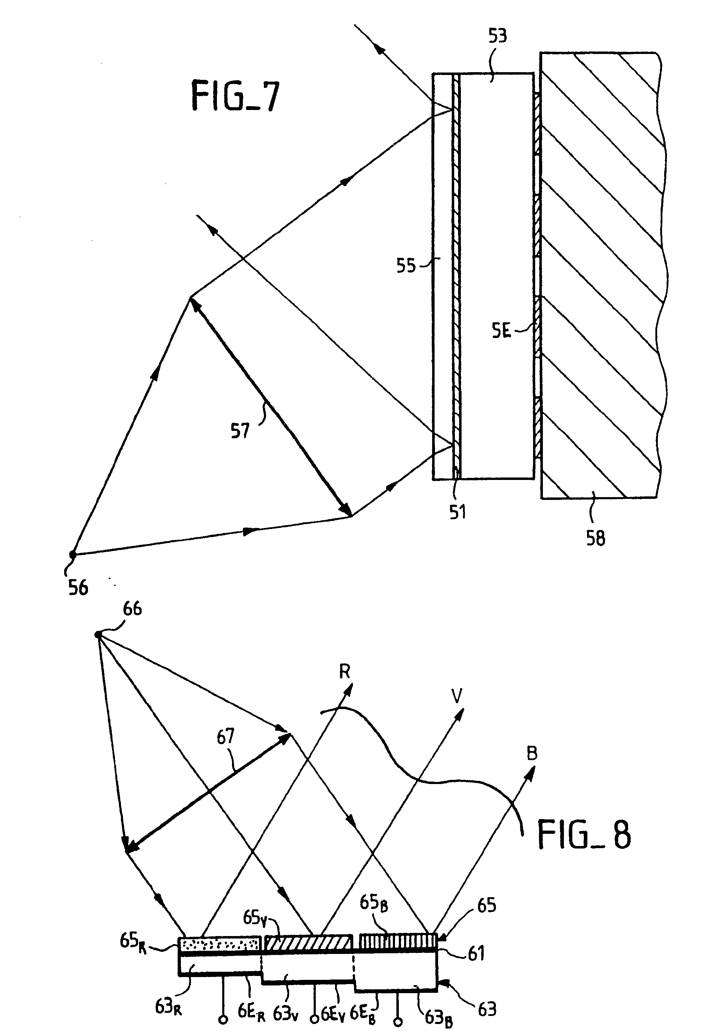

Cet exemple concerne un modulateur électrooptique spatial pour projection d'images télévision. Cet exemple est illustré par la figure 7 où on a représenté un modulateur à adressage matriciel. Il est constitué d'électrodes lignes réfléchissantes 51 en argent prises en sandwich entre le substrat électrooptique 53 et le réseau de couplage 55. Le substrat 53 comporte, sur sa face externe et en regard des électrodes 51, des électrodes colonnes 5E. Une source monochromatique 56 fournit sur toute la surface du modulateur, par l'intermédiaire de la lentille 57, un faisceau de lumière qui se réfléchit par les électrodes lignes 51, modulé spatialement en fonction des champs électriques représentatifs de l'image à visualiser et induits dans le matériau électrooptique grâce à l'arrangement matriciel formé par les électrodes lignes et colonnes.

A cause de la puissance développée par la source 56, il peut être nécessaire de disposer sur les électrodes colonnes 5E un radiateur thermique 58 réalisé par exemple en silicium, en carbure de silicium, en nitrure d'aluminium ou en métal. Ce radiateur thermique étant aussi conducteur électrique, on l'isolera des électrodes colonnes 5E par une mince couche isolante électriquement, par exemple en silice, en alumine ou en polymère isolant.

Dans le cas où on utilise le silicium comme radiateur thermique, on peut concevoir d'utiliser cette masse de silicium pour réaliser les circuits de commande du modulateur en structure monolithique. On peut aussi déposer une couche de silicium amorphe (1 à 2 µm d'épaisseur) sur un substrat isolant électriquement et destiné à constituer le radiateur thermique pour y élaborer des éléments de commande des électrodes colonnes (par exemples des transistors TFT) selon la technique des afficheurs à cristaux liquides.

L'un des intérêts de ce modulateur est la polychromaticité des couches utilisées. En effet, le fonctionnement est possible à n'importe quelle longueur d'onde puisqu'il suffit d'adapter le matériau employé pour les couches. Surtout, on peut optimiser le système couche métallique réfléchissante-substrat électrooptique pour chacune des couleurs, ce qui n'est pas le cas (de façon simple) avec les systèmes de l'art connu, par exemple ceux décrits dans l'article "Electronic Projection Displays" (Seminar 14, R. I. FEIGENBLATT, IBM T. J. Watson Research Center, Yorktown Heights, NY, SID 1987).

## EXEMPLE 5

Cet exemple concerne une variante du modulateur de l'exemple 4. Il est illustré par la figure 8 qui représente un modulateur électrooptique spatial pour projection d'images en couleurs à partir de la réflexion d'un faisceau lumineux blanc.

Ce modulateur est constitué d'électrodes réfléchissantes 61, en argent par exemple, prises en sandwich entre le réseau de couplage 65 et le substrat électrooptique 63. Un élément d'image de ce modulateur comprend trois zones destinées à fournir des faisceaux réfléchis de couleur rouge, verte et bleue (couleurs primaires). La figure 8 ne représente, par souci de simplification, qu'un élément d'image. A chaque zone de l'élément d'image correspondent des parties du réseau de couplage et du substrat électrooptique de nature particulière. Ainsi, le réseau de couplage comprend une première partie $65_R$ absorbant les couleurs complémentaires au rouge, une seconde partie $65_V$ absorbant les couleurs complémentaires au vert et une troisième partie $65_B$ absorbant les couleurs complémentaires au bleu. Les matériaux absorbants peuvent être ceux employés dans le domaine des afficheurs à cristaux liquides en couleurs et peuvent être déposés selon les techniques connues de l'homme du métier. Le substrat électrooptique comprend, par élément d'image, des parties $63_R$, $63_V$ et $63_B$ d'épaisseurs différentes comme cela est montré sur la figure 8. L'épaisseur des différentes parties référencées 63 sera de l'ordre du µm. Ainsi, à la zone de l'élément d'image destinée à fournir un faisceau réfléchi de couleur rouge correspond l'épaisseur du substrat la plus faible. A la zone destinée à fournir un faisceau réfléchi de couleur verte correspond une épaisseur de substrat moyenne. A la zone destinée à fournir un faisceau réfléchi de couleur bleue correspond l'épaisseur de substrat la plus grande.

Pour un élément d'image, l'électrode 61 peut être commune aux trois zones rouge, verte et bleue. Par contre, en vis-à-vis de l'électrode 61 il faut disposer trois électrodes $6E_R$, $6E_V$ et $6E_B$ à raison d'une électrode par couleur.

Les signaux électriques de commande seront appliqués entre l'électrode 61 d'une part et les électrodes $6E_R$, $6E_V$ et $6E_B$ d'autre part. Il est avantageux, pour commander la totalité du modulateur, de disposer d'un arrangement matriciel de lignes et de colonnes.

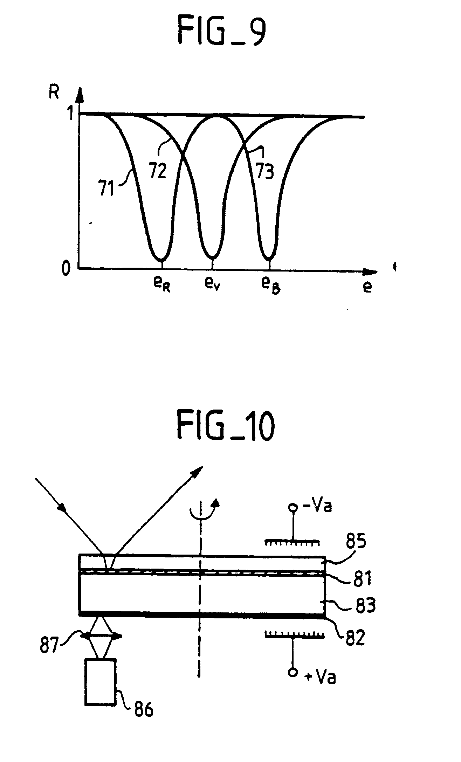

Les couleurs sont sélectionnées automatiquement par l'épaisseur du substrat électrooptique. La figure 9 est un diagramme de réflectivité de la structure de base de l'invention (mince couche métallique sur un matériau diélectrique) en fonction de l'épaisseur du substrat avec comme paramètre la longueur d'onde du faisceau lumineux incident, l'angle θ d'incidence étant fixe. La courbe 71 correspond à la longueur d'onde d'un faisceau lumineux rouge, la courbe 72 correspond à la longueur d'onde d'un faisceau lumineux vert et la courbe 73 correspond à la longueur d'onde d'un faisceau lumineux bleu. Les épaisseurs des différentes zones du substrat électrooptique sont choisies de façon qu'en absence de signal électrique de commande la réflectivité de l'électrode 61 est minimale. Ainsi la figure 9 donne les valeurs des épaisseurs des parties du substrat correspondant au rouge (e$_R$), au vert (e$_V$) et au bleu (e$_B$).

Une source 66 de lumière blanche fournit sur toute la surface du modulateur, par l'intermédiaire de la lentille 67, un faisceau de lumière en direction des électrodes 61. Pour un élément d'image, si aucune tension de commande n'est appliquée aux électrodes des trois zones composant cet élément d'image, rien ne sera réfléchi et l'élément paraîtra noir. En appliquant les tensions de commande appropriées aux différentes zones du substrat électrooptique, on peut ainsi réfléchir des faisceaux de couleurs rouge R, verte V et bleue B.

EXEMPLE 6

Cet exemple concerne la lecture optique d'une mémoire WRM à substrat ferroélectrique. Il est illustré par la figure 10.

La mémoire représentée a la forme d'un disque et comprend une électrode réfléchissante 81, en argent par exemple, prise en sandwich entre le réseau de couplage 85 et le substrat électrooptique 83. Ce substrat électrooptique est aussi ferroélectrique. On peut utiliser une couche d'environ 1 μm d'épaisseur de fluorure de vinylidène ou ses copolymères à base de trifluoroéthylène. La face du substrat 83 située en vis-à-vis de l'électrode 81 est recouverte d'une couche 82 destinée à absorber le faisceau d'écriture fourni par un laser 86.

L'inscription des informations se fait de la manière suivante. Le substrat ferroélectrique est polarisé par effet Corona par application des tensions continues +Va et -Va. Ensuite, le laser d'enregistrement 81 chauffe localement le substrat 85 par émission d'un faisceau lumineux concentré par la lentille 87. Avec une puissance de 10 mW, le débit d'enregistrement peut atteindre 10 MBit/s. Le chauffage dépolarise des zones du substrat ferroélectrique et fait varier localement l'indice optique. On peut obtenir, par chauffage, une succession de zones possédant un premier état de polarisation (par exemple d'indice n = 1,41) ou un deuxième état de polarisation (par exemple d'indice n = 1, 43).

La lecture se fait selon l'invention par un faisceau laser ponctuel d'environ 1 μm² de surface dirigé vers l'électrode 81 et réfléchi vers un photodétecteur en fonction de la modulation de réflectivité de la couche métallique 81.

Par exemple, pour un bit 1 enregistré, l'indice n vaut 1, 43 ce qui conduit à une absence de réflexion et à un courant délivré par le photodétecteur nul. Pour un bit 0 enregistré, l'indice n vaut 1,41 ce qui conduit à une réflexion et à une certaine valeur non nulle de courant délivré par le photodétecteur. Le débit de lecture n'est pas limité.

L'intérêt de ce système est que la mémoire peut être lue optiquement et effacée optiquement autant de fois que l'on veut. Le système de lecture est extrêmement sensible et de grande dynamique (supérieure à 40 dB), ce qui est garant d'un faible taux d'erreur.

Revendications

1 - Modulateur électrooptique spatial caractérisé en ce qu'il comprend un substrat en matériau électrooptique (3) recouvert de moyens métalliques de réflexion (1) et comprenant des moyens d'application d'un champ électrique au substrat, (1) et (E), l'épaisseur de la couche métallique et l'indice de réfraction du substrat étant tels qu'un champ électrique appliqué au substrat induit une variation de la valeur de la réflectivité de la couche métallique.

2 - Modulateur éleectrooptique spatial selon la revendication 1, caractérisé en ce que des moyens de couplage optique (5) sont disposés sur les moyens métalliques de réflexion (1) .

3 - Modulateur électrooptique spatial selon la revendication 2, caractérisé en ce que les moyens de couplage optique (5) sont constitués par un réseau.

4 - Modulateur électrooptique spatial selon l'une quelconque des revendications 1 à 3, caractérisé en ce que les moyens d'application d'un champ électrique au substrat comprennent d'une part lesdits moyens métalliques de réflexion (1) et d'autre part au moins une électrode (E) située sur la face du substrat (3) opposée à celle supportant les moyens métalliques de réflexion.

5 - Modulateur électrooptique spatial selon la revendication 4, caractérisé en ce que les moyens d'application (1) et (E) d'un champ électrique au substrat forment un arrangement matriciel de lignes et de colonnes.

6 - Modulateur électrooptique spatial selon l'une quelconque des revendications 1 à 5, caractérisé en ce que ledit substrat (3) est un polymère.

7 - Modulateur électrooptique spatial selon l'une quelconque des revendications précédentes, caractérisé en ce qu'il comprend un substrat (3) à base de matériau semiconducteur pour y élaborer des éléments de commande permettant l'application dudit champ électrique.

8 - Lecteur optique de signaux hydrophoniques, caractérisé en ce qu'il comprend un modulateur électrooptique spatial selon l'une quelconque des revendications 1 à 6, le modulateur fournissant une image en fonction des signaux hydrophoniques appliqués au substrat électrooptique (23).

9 - Interrupteur optique à mémoire spatiale, caractérisé en ce qu'il comprend un modulateur électrooptique selon l'une quelconque des revendications 1 à 6, le substrat électrooptique (43) étant un matériau ferroélectrique, des moyens de chauffage étant prévus pour élever localement la température du substrat électrooptique pour le dépolariser, le modulateur étant localement réfléchissant ou non selon l'état de polarisation du substrat électrooptique.

10 - Projecteur d'images télévision, caractérisé en ce qu'il comprend un modulateur électrooptique spatial selon l'une quelconque des revendications 1 à 6, une source de lumière (56) fournissant un faisceau de lumière en direction desdits moyens métalliques de réflexion (51) qui réfléchissent un faisceau modulé spatialement en fonction de signaux électriques représentatifs de l'image à visualiser et appliqués au substrat électrooptique (53) par l'intermédiaire desdits moyens d'application.

11 - Projecteur d'images télévision en couleurs, caractérisé en ce qu'il comprend un modulateur électrooptique spatial selon l'une quelconque des revendications 1 à 6, une source de lumière blanche (66) fournissant un faisceau de lumière en direction desdits moyens métalliques de réflexion (61) qui réfléchissent un faisceau modulé spatialement en fonction de signaux électriques représentatifs de l'image à visualiser et appliqués au substrat électrooptique (63) par l'intermédiaire desdits moyens d'application, le modulateur étant décomposable en éléments d'image, chaque élément d'image comprenant trois zones correspondant aux trois couleurs primaires, le substrat électrooptique ayant pour chaque zone une épaisseur déterminée de façon à sélectionner une couleur primaire, des moyens d'absorption de couleurs complémentaires étant également prévus pour que chaque zone réfléchisse un signal modulé de l'une des trois couleurs primaires.

12 - Projecteur d'images télévision selon la revendication 11, caractérisé en ce que les moyens d'absorption de couleurs complémentaires sont constitués par les moyens de couplage optique (65).

13 - Projecteur d'images télévision selon l'une quelconque des revendications 10 à 12, caractérisé en ce qu'il comprend un radiateur thermique en matériau semi-conducteur (58) situé sur le modulateur et du côté opposé aux moyens métalliques de réflexion (51), des éléments de commande y étant élaborés pour permettre l'application d'un champ électrique au substrat électrooptique (53).

14 - Système optique comportant une mémoire, caractérisé en ce qu'il comprend un modulateur électrooptique spatial selon l'une quelconque des revendications 1 à 6, le substrat électrooptique (83) étant ferroélectrique et étant destiné à constituer la mémoire par polarisation locale ou absence de polarisation, le modulateur étant localement réfléchissant ou non selon l'état de polarisation du substrat électrooptique.

15 - Système optique selon la revendication 14, caractérisé en ce qu'il comprend des moyens de polarisation électrique de l'ensemble du substrat électrooptique pour l'amener à un premier état de polarisation déterminé et des moyens de chauffage localisé pour induire localement un deuxième état de polarisation.

16 - Système optique selon la revendication 14, caractérisé en ce que les moyens de polarisation électrique sont du type à effet Corona.

17 - Système optique selon l'une des revendications 14 ou 15, caractérisé en ce que les moyens de chauffage localisé comprennent un laser (86).

# FIG_1

# FIG_2

Pic de plasmon
de surface

FIG_3

FIG_4

## FIG_5

FAISCEAU IR

FAISCEAU IR MODULE

35

31

33

3E

3E

## FIG_6

43

41

4E

45

LASER

LASER

LASER

LASER

12

FIG_7

FIG_8

## FIG_9

## FIG_10

Office européen
des brevets

**RAPPORT DE RECHERCHE EUROPEENNE**

Numero de la demande

EP 91 40 0117

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | EP-A-0 124 622 (MATSUSHITA) * Page 2, ligne 12 - page 6, ligne 12; page 9, lignes 14-27 * | 1,2,5 | G 02 F 1/19 H 04 N 9/31 |
| A | | 9,10 | |
| X | IBM TECHNICAL DISCLOSURE BULLETIN, vol. 22, no. 8B, janvier 1980, pages 3801-3802, New York, US; J.D. SWALEN: "High frequency light modulator or display" * Le document en entier * | 1,5 | |
| A | US-A-4 451 123 (McNeill et al.) * Colonne 1, ligne 31 - colonne 4, ligne 39 * | 1,2 | |
| A | APPLIED OPTICS, vol. 27, no. 21, novembre 1988, pages 4587-4590; J.S. SCHILDKRAUT: "Long-range surface plasmon electrooptic modulator" * Chapitres I,II * | 1,2 | |
| A | FR-A-2 512 951 (THOMSON CSF) * Page 2, ligne 33 - page 8, ligne 8 * | 1,2,8 | DOMAINES TECHNIQUES RECHERCHES (Int. Cl.5) G 02 F 1 |

Le présent rapport a été établi pour toutes les revendications

| Lieu de la recherche | Date d'achèvement de la recherche | Examinateur |
|---|---|---|
| LA HAYE | 03-05-1991 | DIOT P.M.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)